# EUROPEAN PATENT APPLICATION

(11) **EP 4 250 006 A1**
(43) Date of publication of application: **27.09.2023**
(21) Application number: 22163867.9
(22) Date of filing: 23.03.2022
(51) Int. Cl.: G03F 7/00, B82Y 40/00, G06T 7/00, B29C 43/58

(54) **QUALITY CONTROL METHOD FOR IMPRINT LITHOGRAPHY**

(71) Applicant: Koninklijke Philips N.V., 5656 AG Eindhoven (NL)
(72) Inventor: VAN BRAKEL, Remco, Eindhoven (NL); VERSCHUUREN, Marcus Antonius, Eindhoven (NL)
(74) Representative: Philips Intellectual Property & Standards

(57) **Abstract**

A method for quality assessment in imprint lithography which is based on analyzing the quality of an imprintable layer based on indirect detection of its viscosity. The method comprises imprinting a dedicated test pattern comprising multiple pattern sections, comprising pattern indentations of differing widths and/or depths. The viscosity of the imprintable layer affects how it flows to fill the lithographic imprint pattern, and higher viscosity results in uneven (at a micro or nano scale) layer geometry (i.e. curved or bowed) in each groove or on each ridge of the indentation pattern. This unevenness is detectable upon optical inspection, due to a thin-film interference pattern caused by the passage of light through the uneven imprintable layer surface, and back-reflection from an underlying substrate, this being detectable in captured optical image data. Thus, the viscosity of the imprintable layer is indirectly detectable via capturing optical image data of the test pattern. By using multiple different pattern sections of differing width and depth, a precise quantitative measure of viscosity-related quality can be identified.

## Description

### FIELD OF THE INVENTION

The present invention relates to the field of imprint lithography, and in particular to a method for quality control assessment in the context thereof.

### BACKGROUND OF THE INVENTION

Imprint lithography (IL) is a technique in which a patterned layer such as a masking layer is formed on a substrate such as a semiconductor substrate or as an optical layer by the deposition of an imprintable medium. The imprintable medium is subsequently patterned by imprinting the medium with a patterned stamp having a relief pattern on one of its surfaces. In some cases a curable imprintable medium is used, in which case the curable imprintable medium is subsequently solidified e.g. when exposed to light, e.g. UV-light to initiate the curing reaction in the medium. Alternatively, hot embossing can be used. After the imprinting is completed, the stamp is removed from the medium to leave a patterned layer, e.g. on the semiconductor substrate or on a carrier of such an optical layer. Where it serves as a mask layer, it may be referred to as a resist layer.

SCIL (substrate conformal imprint lithography) technology is one variety of imprint lithography. Imprinting results from capillary forces rather than pressure so that any changes in structure are avoided during the contact process. Furthermore, the sequential contact routine does not allow air gaps/inclusions to form, which results in high yields and increases productivity.

In the context of high volume imprint lithography manufacturing processes (e.g. semiconductor manufacture), quality control measures are needed. Quality control can be used to check the quality of the various layers in a layered fabrication process. Quality control involves analysis of the layered structure at one or more stages throughout the manufacture. It is preferable if quality control analysis can be performed in-line with manufacture.

Quality control analysis of imprint lithography processes involves analyzing the structural properties of the patterned imprintable layer.

Well-known methods to analyze small structures are microscopy, for example scanning electron microscopy (SEM) and Atomic Force Microscopy (AFM). Other methods include white light interferometry. The appropriate method depends upon the size of the target object. For nano structures, SEM is more suitable but is expensive and requires large machinery with high spatial footprint.

AFM provides detailed and accurate analysis of structures but is time-consuming. SEM can provide a detailed view of the surface of the structures, but its expense, complexity and large spatial footprint makes it somewhat impractical for inline quality control.

An alternative approach to quality control of imprint lithographic processes is sought.

### SUMMARY OF THE INVENTION

The invention is defined by the claims.

In substrate conformal imprint lithography (SCIL) a viscous imprintable layer is brought into contact with a relief surface of a pliable (usually rubber, e.g. PDMS) stamp. Upon contact, the relief features of the stamp, usually having dimensions in the micrometer or smaller scale, fill with the viscous material of the imprint layer. This process may be referred to as a conformation process of the imprintable layer to the relief surface. After good conformation has been achieved, the imprintable layer is solidified while in contact with the stamp. Once solidification is complete, the stamp is removed or released.

It is a realization of the inventors that a structural or material quality of the imprintable layer can be assessed based on indirect detection of the layer's viscosity or flow properties which are a relevant parameter in assessing material quality of the layer. A quality control method has therefore been sought by the inventors which provides an indication of this viscosity.

It is a further realization of the inventors that the viscosity or flow properties of the layer can be assessed via analysis of a quality of the above-described conformation process, in particular based on optically analyzing the imprintable layer after imprinting and solidification to detect a morphology of the imprinted relief pattern.

In this regards, in accordance with an aspect of the invention, there is provided a quality control method for use in imprint lithography, the method comprising:
providing a patterned stamp for patterning an imprintable layer, the stamp comprising a pliable stamp layer carrying a pattern of relief features which define a stamp pattern,
wherein the stamp pattern comprises a plurality of pattern sections, the pattern sections spaced from one another, and wherein each pattern section comprises pattern features for forming at least one depression of a respective width which is different compared to that of the other pattern sections;
applying the stamp to an imprintable layer disposed on a substrate, the imprintable layer comprising a curable imprintable medium, whereby the imprintable layer is induced to conform to the stamp pattern;
acquiring, optical imaging data of the imprint pattern in the imprintable layer;
deriving, based on the optical imaging data and based on knowledge of the differing widths and/or depths of the pattern section depressions, a conformation quality indicator indicative of layer-stamp conformation quality.

Embodiments of the invention are based on analyzing the quality of the imprintable layer based on indirect detection of its viscosity. The viscosity of the imprintable layer affects how it flows to fill the lithographic stamp pattern upon application of the stamp, and higher viscosity results in an uneven (at a micro or nanoscale) imprintable layer geometry (i.e. curved or bowed) in each depression/groove or on each ridge of the imprint pattern. This unevenness is detectable upon optical inspection, due to optical effects caused by incident light upon or through a non-flat reflecting surface, for example through spectroscopic (e.g. color) analysis. For example, the unevenness is detectable upon optical inspection, due to a thin-film interference pattern caused by the passage of light through the uneven thin imprintable layer surface, and back-reflection from an underlying substrate, this being detectable in captured optical image data. By providing an imprint pattern which has multiple spatially separated regions, each defining imprint depressions of different width, a more precise quantitative measure of viscosity-related quality can be identified. In particular, since the 'filling' quality of the layer in the grooves/ridges can be expected to be different for grooves/ridges of a different size and the filling quality vs ridge size function will differ for differing layer viscosities.

The stamp can be a dedicated quality control stamp, or it may be stamp which is used in the main manufacturing process. For example, in the latter case, the above-described stamp pattern could be provided in one spatial region of the functional stamp, i.e. a test area of the main stamp, similar to alignment test blocks in high-volume printing processes.

Each of the aforementioned pattern sections occupies a separate respective spatial region of the stamp surface. They might otherwise be referred to as pattern regions.

In some examples, the imprintable layer may be a curable imprintable layer. In this case, the method may further comprise a step, after applying the stamp, of: curing the imprintable layer for a predetermined time period to thereby form a cured imprint pattern in the surface of the imprintable layer, and wherein the optical imaging data is acquired after the curing. An alternative to a curing method is for example hot embossing which does not require a curing step.

With regards to the geometry or shape of the depression mentioned above, the inventive concept is not dependent on any specific geometry or shape. The important factor is the provision of different widths and/or depths in the different spatial sections of the stamp pattern, so that the differing fill quality in each different depression depth or width can be compared. It is preferable if the general outline geometry or shape of the at least one depression is the same in every pattern section, and differs only in width or depth between the different pattern sections. This makes the sections easier to compare.

In one particular set of embodiments, it is proposed to provide in each pattern section a respective line grating relief pattern, to form a respective grating of imprinted lines when that section is applied to the imprintable layer. Thus, in this example, the at least one depression comprises at least one elongate, linear depression, i.e. a linear groove.

In particular, according to at least one set of embodiments, each pattern section may comprises relief features which define a respective grating of parallel lines for forming line depressions in the imprintable layer, the grating having a grating pitch and a grating duty cycle which together define an uniform grating line width of each of the line depressions, and a grating depth which defines a depth of each of the line depressions. The grating duty cycle is a term of the art and means the ratio of the grating ridge width to the grating pitch (where the pitch is otherwise known as the grating period). If the grating is understood as an alternating pattern of line depressions (grooves) and line ridges, and wherein the grating period or pitch is the distance covered by one depression and one ridge, then the grating duty cycle is effectively the proportion of that period distance which is covered by the width of the ridge (as opposed to the line width of the depression).

The benefits of a line grating for each pattern section include provision of a simple and uniform geometry for every pattern section (therefore making the resulting imprint pattern easily comparable between sections) and simple manufacturing.

The grating of each of the plurality of pattern sections may have a different respective line pitch compared to the other pattern sections. Preferably, each of the plurality of pattern sections at least has a different line pitch resulting in a different grating depression line width compared to the other pattern sections, and optionally further has a different depression line depth.

In one advantageous set of embodiments, there are provided a plurality of sets of gratings, each set providing gratings imprinted to a same common depth, with the depths differing between the sets. For example, the plurality of pattern sections may include at least a first set of two or more gratings, and a second set of two or more gratings, the gratings of the first set comprising lines of a first depth, and the gratings of the second set comprising lines of a second depth, and wherein each of the first and second sets of gratings include respective gratings of a plurality of different line pitches and/or grating duty cycles. In this way, there is achieved a plurality of grating pitches at a plurality of different depths.

With regards to the scale of the depression widths, the width of the at least one depression of each pattern section may be between 0.5 and 200 micrometers.

In relation more specifically to the set of embodiments in which each pattern section comprises a respective line grating, the depression line width of each grating may be between 0.5 and 200 micrometers.

With regards to the determining of the conformation quality indicator, in general, this can be done based on comparing one or more optical characteristics of the light reflection pattern from each of the pattern sections.

In some embodiments, the determining the conformation quality indicator may comprise detecting from the optical image data a spatial color distribution or pattern exhibited by each pattern section, and determining based on the color pattern of each pattern section, and based on knowledge of the width and/or depth of the at least one depression of each pattern section, an indicator of conformation quality.

As briefly discussed above, the viscosity of the imprintable layer affects how it flows to fill the lithographic imprint pattern, and higher viscosity results in uneven (at a micro or nanoscale) geometry of the imprintable layer (i.e. curved or bowed) in each groove or on each ridge. This unevenness is detectable upon optical inspection, due to optical effects caused by incident light upon a non-flat reflecting surface, e.g. a thin film interference pattern of light travelling through the uneven layer. One expression of this is in detectable color changes. Thus, the viscosity of the imprintable layer is indirectly detectable via capturing the color pattern of the reflected light from each pattern section. More generally, the method may comprise a spectroscopic analysis of the optical image data, based on detecting a spectroscopic or optical frequency pattern exhibited by each pattern section.

In some embodiments, the method may further comprise detecting from the color pattern for each pattern section a color variation pattern across a width of the at least one depression.

The method may further comprise determining for each pattern section a color uniformity metric representative of a degree of color uniformity across the width of the at least one depression based on said detected color variation across the width of the depression.

In some embodiments, the method may further comprise determining the conformation quality indicator based on comparing the color uniformity metric of each pattern section against a pre-defined standard, such as a threshold range.

In some embodiments, the determining the conformation quality indicator may comprise identifying the maximum depression width, among the differing depression widths of the plurality of pattern sections, for which the corresponding color uniformity metric meets said pre-defined standard.

With regards to deriving a quality indicator, ultimately a quality assessment seeks to determine if the layer viscosity is such that the conformation quality with the stamp is at a required minimum level for the particular lithography operation which is to be performed. Higher conformation quality permits finer spatial resolution of imprinted patterns. The detected color pattern is indicative of characteristics of the physical engagement between the stamp and the imprintable layer, by virtue of the degree of geometrical uniformity of the generated depressions. The detected color pattern is related to the refraction of light through the imprintable layer at the base of the depressions of the pattern section. In particular, the color across the width of a given depression may be expected to vary with a particular variation function or pattern which differs according to the degree of uniformity of the depression(s) of the pattern section. Thus, a quality of conformation for a given pattern section can be indicated by a color pattern for that section, and the overall conformation quality indicator of the imprintable layer can be derived from assessment of the quality of the layer across the whole set of pattern sections. The quality of a given pattern section may be determined in dependence upon a degree of color uniformity along the width of the depressions for that section. For example, the color pattern of each pattern section could be used to derive a pattern section quality metric, each pattern section quality metric compared with a threshold level or range, and an overall conformation quality indicator could be defined in dependence upon which of the pattern sections has an associated pattern section quality metric which meets the defined threshold. For example, as noted above, there may be identified the maximum depression width, among the differing depressions widths of the plurality of pattern sections, for which the corresponding color uniformity metric meets said pre-defined standard.

In this context, it is noted that color can be quantitatively defined with various color metrics, including RGB color values (or other standard color code), or simply based on corresponding light frequency or wavelength or spectral composition.

In some embodiments, the method may further comprise detecting from the color pattern for each pattern section a degree of color uniformity of one or more of: a peak of the imprint pattern section, and a non-imprinted region surrounding the pattern.

In some embodiments, for each pattern section, the detected degree of color uniformity of the peak of the imprint pattern section or of the non-imprinted region surrounding the pattern may be used as the previously mentioned pre-defined standard .

In some embodiments, the determining the conformation quality indicator may comprise, for each pattern section, determining from the color variation pattern across the width of the at least one depression of the pattern section a degree of height non-uniformity across a base of said at least one depression based on an assumption that the color variation is indicative of an optical thin-film interference pattern of incident light through the imprintable layer.

In some embodiments, the method may further comprise comparing the derived degree of height non-uniformity with at least one threshold, and deriving the conformation quality indicator based thereon.

In some embodiments, the previously mentioned optical imaging data may be acquired using an optical microscope. The optical microscope may have a magnification of at least 1000x.

In some embodiments, the imprintable layer may comprise a resist layer, e.g. a mask layer.

In some embodiments, the stamp may be a Substrate Conformal Imprint Lithography (SCIL) stamp.

A further aspect of the invention provides an imprint lithography stamp having a patterned surface for patterning an imprintable layer, the stamp comprising a pliable stamp layer carrying a pattern of relief features which define a stamp pattern. The stamp pattern comprises a plurality of pattern sections, the pattern sections spaced from one another, and wherein each pattern section comprises pattern features for forming one or more depressions of a respective width which is different compared to the other pattern sections.

In some embodiments, each pattern section may comprise relief features which define a respective grating of parallel lines for forming line depressions in the imprintable layer, the grating having a grating pitch which defines a width of each of the line depressions, and a grating depth which defines a depth of each of the line depressions.

In some embodiments, the grating of each of the plurality of pattern sections may have a different respective line pitch and/or depth compared to the other pattern sections.

These and other aspects of the invention will be apparent from and elucidated with reference to the embodiment(s) described hereinafter.

### BRIEF DESCRIPTION OF THE DRAWINGS

For a better understanding of the invention, and to show more clearly how it may be carried into effect, reference will now be made, by way of example only, to the accompanying drawings, in which:
Fig. 1 schematically illustrates an example patterned stamp for use in forming an imprint pattern for a quality control analysis;
Fig. 2 schematically illustrates a further example patterned stamp for use in forming an imprint pattern for a quality control analysis;
Fig. 3 illustrates steps for forming an imprint pattern as part of an example quality control method; and
Fig. 4 shows optical analysis of a formed imprint pattern for quality control assessment.

### DETAILED DESCRIPTION OF THE EMBODIMENTS

The invention will be described with reference to the Figures.

It should be understood that the detailed description and specific examples, while indicating exemplary embodiments of the apparatus, systems and methods, are intended for purposes of illustration only and are not intended to limit the scope of the invention. These and other features, aspects, and advantages of the apparatus, systems and methods of the present invention will become better understood from the following description, appended claims, and accompanying drawings. It should be understood that the Figures are merely schematic and are not drawn to scale. It should also be understood that the same reference numerals are used throughout the Figures to indicate the same or similar parts.

The invention provides a method for quality assessment in imprint lithography which is based on analyzing the quality of an imprintable layer based on indirect detection of its viscosity. The method comprises imprinting a dedicated test pattern comprising multiple pattern sections, comprising pattern indentations of differing widths and/or depths. The viscosity of the imprintable layer affects how it flows to fill the lithographic imprint pattern, and higher viscosity results in uneven (at a micro or nano scale) layer geometry (i.e. curved or bowed) in each groove or on each ridge of the indentation pattern. This unevenness is detectable upon optical inspection, due to a thin film interference pattern caused by the passage of light through the uneven imprintable layer surface, and back-reflection from an underlying substrate, this being detectable in captured optical image data. Thus, the viscosity of the imprintable layer is indirectly detectable via capturing optical image data of the test pattern. By using multiple different pattern sections of differing width and depth, a precise quantitative measure of viscosity-related quality can be identified.

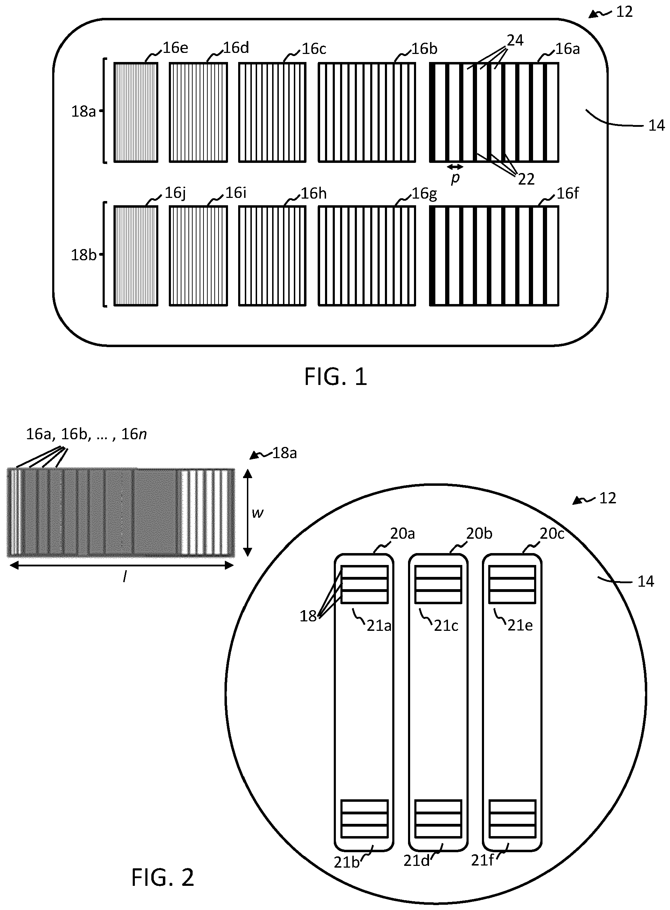

Fig. 1 schematically illustrates an example imprint lithography stamp 12 for use in an imprint lithography quality control method. The stamp may in some examples be a Substrate Conformal Imprint Lithography (SCIL) stamp.

The stamp comprises a pliable layer 14, e.g. formed of an elastomeric material such as rubber. The layer carries on an exposed surface a pattern of relief features 22 which define a stamp pattern. The stamp pattern comprises a plurality of pattern sections 16a-j, the pattern sections being spaced from one another. Although ten pattern sections are shown in Fig. 1, this is just an example and more or fewer pattern sections may alternatively be provided. Each pattern section 16 comprises relief features 22 for forming at least one depression 24 of a respective width and/or depth which is different compared to that of the other pattern sections.

In the illustrated examples, each pattern section 16 comprises relief features 22 for forming at least one depression 24 of a respective combination of width and depth which is different compared to that of the other pattern sections.

In the illustrated example, each pattern section 16 comprises relief features 22 which define a respective grating of parallel lines for forming line depressions 24 in the imprintable layer. Each grating has a grating pitch, p, (otherwise known as a grating period). Each grating has a duty cycle. The duty cycle means the ratio of the grating ridge width to the grating pitch, p. If the grating is understood as an alternating pattern of line depressions (grooves) and line ridges, and wherein the grating period or pitch is the distance covered by one depression and one ridge, then the grating duty cycle is effectively the proportion of that period distance which is covered by the width of the ridge (as opposed to the line width of the depression). The pitch and duty cycle together define a uniform grating line width of each of the line depressions, and a grating depth which defines a depth of each of the line depressions.

In this particular example, the plurality of pattern sections 16 comprises a first set 18a of gratings, and a second set 18b of gratings, the gratings of the first set comprising lines of a first depth, and the gratings of the second set comprising lines of a second depth, and wherein each of the first and second sets of gratings include gratings respectively of a plurality of different line pitches and line widths. For example, each grating may have a depression line width between 0.5 µm and 200 µm. In other words, each pattern section is configured to form line depressions having a width of between 0.5 µm and 200 µm. With regards to the respective depths of the first set 18a and second set 18b of gratings, these may for example be depths between 75 and 300 nm, In some examples, the depths may be selected as any two of: 75 nm, 150 nm and 300 nm.

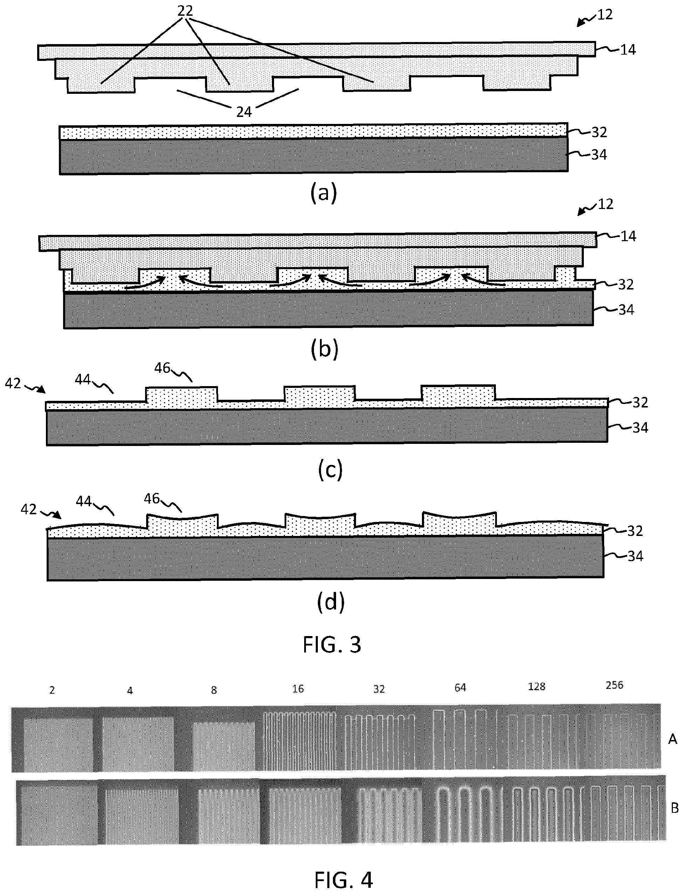

Although two sets 18a, 18b of gratings are shown in the example of Fig. 3, in further examples, a greater number of sets of gratings may be provided, for example three sets of gratings, or more than three sets of gratings.

With regards to the number of line depressions 24 of each grating, this can in fact be any number of one or more, although the reliability of the optical analysis (described below) may be improved if each grating provides a greater number of line depressions.

The stamp is used for performing a quality control assessment in the context of an imprint lithography process. More particularly, the stamp is for assessing the quality of an imprintable layer which is lithographically imprinted as part of the imprint lithography process.

One aspect of the invention is the patterned stamp used in the quality control method. Another aspect of the invention is the quality control method itself, using the patterned stamp. The basic steps of the method will now be described.

The method comprises providing a patterned stamp 12 carrying a pattern of relief features which define a stamp test pattern. The stamp test pattern may for example be as described above with reference to Fig. 1. More generally, the stamp test pattern should comprise a plurality of pattern sections 16, the pattern sections spaced from one another, and wherein each pattern section comprises pattern features 22 for forming at least one depression 44 of a respective width and optionally also depth which is different compared to that of the other pattern sections.

The method comprises applying the stamp to an imprintable layer applied on a substrate, the imprintable layer comprising an imprintable medium, whereby the imprintable layer is induced to conform to the stamp pattern.

If the imprintable medium is a curable imprintable medium, then the method further comprises curing the imprintable layer for a predetermined time period to thereby form a cured imprint pattern in the surface of the imprintable layer. However, a curable imprintable medium is not essential. Another alternative for example is a hot embossing process which does not require a curing step.

The method further comprises acquiring optical imaging data of the formed imprint pattern in the imprintable layer.

The method further comprises deriving, based on the optical imaging data and based on knowledge of the differing depression widths and/or depths of pattern sections, a conformation quality indicator indicative of layer-stamp conformation quality.

Fig. 2 shows a further example patterned stamp 12 in accordance with one or more embodiments. The stamp may in some examples be a Substrate Conformal Imprint Lithography (SCIL) stamp.

In this example, the stamp pattern comprises three pattern blocks 20a, 20b, 20c. Each pattern block comprises a plurality of sets 18 of stamp pattern sections 16. Each pattern section 16 comprises stamp relief features which define one or more depressions of a particular width. In this example, each pattern section 16 comprises relief features which define a respective line grating of a particular pitch and groove line width. One example set 18a of pattern sections 16 (in the form of line gratings) is illustrated at item 18a in Fig. 2. Within each respective set 18 of gratings, each grating 16 has a different pitch and line width. The pitches vary from a minimum pitch to a maximum pitch to thereby form, when the stamp is applied, a series of line depressions of different widths. In this particular example, the pitches of the gratings 16 vary from a minimum pitch of 0.5 µm to a maximum pitch of 200 µm. In some examples, the number of periods in each grating (i.e. the number of lines) may also vary as the pitch varies, so that higher pitch gratings have a smaller period.

Each block 20a, 20b, 20c may correspond to a different imprint depth, so that all of the sets 18 of pattern sections 16 in one block 20 are of the same imprint depth. In the illustrated example, the first block has a depth of 75 nm, the second block 20b has a depth of 150 nm and the third block 20c has a depth of 300 nm. These are exemplary only, and do not in any way limit the scope of the inventive concept.

In some examples, the sets 18 of line gratings may vary between one another also in their grating duty cycle. For example, Fig. 2 illustrates a design in which, within each block, there are multiple sets 18 of gratings 16, each set of gratings comprising gratings of the same range of pitches and line widths, but varying in their grating duty cycle (meaning the proportion of each grating period which is spatially spanned by the ridge part of the grating (as opposed to the depression). In the particular example of Fig. 2, each block 20 includes two identical groups 21 of three sets 18 of grating sections 16, wherein the sets 18 of each group are the same as one another except in respect of their grating duty cycle. For example, the three sets 18 of gratings in each group 21 might have respective grating duty cycles of 0.33, 0.5 and 0.66 (this is one example only). Providing gratings with different duty cycles allows to test the flow or viscosity at the beginning of each imprint pattern and at the end.

By providing two identical groups 21 of grating sets 18 in each elongate block, at opposite ends of the block, this allows to test the imprint quality at different times in the imprint.

By way purely of illustration, in the illustrated example, each set 18 of gratings 16 may have a length, *l*, of between 15 mm and 20 mm. For instance, in one prototype built by the inventors, the length was 17.1 mm (non-limiting example only).

By way of further guidance, in the illustrated example, each set 18 of gratings 16 may have a width, w, of between 1 mm and 5 mm. For instance, in one prototype built by the inventors, the width was 3 mm (non-limiting example only).

A horizontal spacing between each neighboring grating sections 16 in a given set 18 of grating sections may by way of example be between 75 µm and 125 µm, for example 100 µm. The horizontal spacing between the neighboring pattern blocks 20a, 20b, 20c may for example be between 1 mm and 5 mm, for example 3 mm.

It is noted that according to at least one set of embodiments, a master stamp mold may be provided, for example in silicon or another suitable material, from which multiple versions of a same pliable stamp may be formed with a same stamp pattern. The pliable stamp itself may be formed from an elastomer material, while the master may be formed from a more rigid material, for example etched into silicon.

For schematic illustration, Fig. 1 and Fig. 2 show example stamps 12 in which the stamp pattern covers a majority of the surface area of the stamp pliable layer 14. In other words, the stamp is a dedicated quality control stamp. For example, the stamp might be applied to a dedicated test piece at intervals throughout a manufacturing process to periodically test a quality of the imprintable layer used in the lithographic imprinting part of the manufacture process. However, in other examples, the test stamp pattern could be provided covering a minority portion of a surface area of a primary stamp used in the lithographic imprinting step of the primary manufacturing process. For example, this may form a test region of the imprint pattern, so that quality of the imprintable layer can be assessed by optical analysis of any piece produced throughout the manufacturing process. This may be more advantageous for facilitating in-line quality control. It is very time consuming to change stamps during a printing run.

The method of imprinting the test stamp 12 and optically analyzing the resulting imprint pattern will now be explained further, with reference to Fig. 3.

A schematic representation of an example stamp 12 is shown in Fig. 3(a). The stamp comprises a pliable stamp layer 14 which carries a pattern of relief features 22 which define a stamp pattern. In the schematic illustration of Fig. 3, only one pattern section is visible, in which the relief features are for forming depressions of a same common width. However, as discussed above, the stamp comprises a plurality of pattern sections, each for forming depressions of different widths.

The substrate may for example be a semiconductor substrate such as silicon.

The imprintable layer may be formed of an elastomeric material. Examples include a sol-gel based material, a sol-gel + nano-particle based material, or a nano-particle only based material. Other examples include UV curing materials, e.g. epoxy curing or acrylate curing. Also, organic material may be used (with cross-linking via UV light or another initiator), or hybrid inorganic-organic materials. By way of further example, the imprintable layer may be formed of a glass-like material such as silicon monoxide (SI-O).

The imprintable layer may be applied to the substrate in a deposition process such as for example spin coating.

The stamp 12 is applied to an imprintable layer 32 disposed on a substrate 34, the imprintable layer comprising a curable imprintable medium, whereby the imprintable layer is induced to conform to the stamp pattern. This step is illustrated schematically in Fig. 3(b). By way of example, the imprintable layer 32 may be a resist layer for use as part of a semiconductor manufacture process, for instance a mask layer. For example, the imprintable layer 32 may be a nanoglass resist layer.

Applying the stamp causes the imprintable layer 32 to flow up into the gaps 24 of the stamp relief pattern, as shown in Fig. 3(b).

After applying the stamp 12, the stamp is retained in position on the imprintable layer 32 and the layer is solidified in a curing process. After curing for a pre-determined period of time, the stamp is removed 12 and a cured imprint pattern 42 is left in the imprintable layer 32. Depending upon the quality of the imprintable layer, the resulting imprint pattern will differ in its quality. In particular, a higher quality imprintable layer will result in greater quality conformation of the layer 32 to the stamp pattern. Fig. 3(c) shows one example of a cured imprint pattern for a high quality imprintable layer 32. Fig. 3(d) shows a further example of a cured imprint pattern for a lower quality imprintable layer.

For the higher quality imprintable layer 32 of Fig. 3(c), the viscosity of the layer is lower, which results in improved layer-stamp conformation quality. This manifests in an imprint pattern 42 which comprises depressions 44 which have a more uniform height at the base of the depressions. It further results in a more uniform height at the top of the peaks 46 of the imprint pattern. This is because a lower quality imprintable layer has higher viscosity and viscosity is for example indicative of a chain length of the polymers and crosslink density in the layer.

For the lower quality imprintable layer 32 illustrated by Fig. 3(d), there is greater height non-uniformity in the layer at the base of each of the depressions 44 of the imprint pattern and at the top of each of the peaks 46 of the imprint pattern. This is because the higher viscosity impairs the proper filling of the layer in the line spaces 24 of the stamp pattern, resulting in poorer quality stamp-layer conformation.

The conformation quality of the imprintable layer 32 to the stamp pattern can be assessed optically by capturing optical imaging data of the resulting imprint pattern 42 in the imprintable layer. This can for example be acquired using an optical microscope. By way of example, an optical microscope may be used with a magnification of approximately 1000x.

For an imprintable layer 32 with poor quality conformation with the stamp 12, the non-uniformity of the layer surface height at the depression 44 bases and at the tops of the peaks 46 results in changes in the optical properties of light reflected from the pattern at these locations. In particular, light incident on the stamp pattern may pass through the thin imprintable layer 32 material, reflect from the substrate 34, and then be received at an optical measuring apparatus, e.g. a microscope or a magnifying photographic apparatus. This results in a thin film interference color pattern in which the color varies across the width the depression, due to the varying height of the depression.

In particular, spectral characteristics of light reflecting from an uneven surface can be expected to differ from those of light reflected from a more even surface. Thus, the degree of surface unevenness in the depressions and at the peaks can be detected based on capturing optical imaging data and performing spectral (e.g. spectroscopic) analysis of the image data. From this, a layer-stamp conformation quality can be deduced, and thus a quality of the imprintable layer deduced.

By way of example, the determining the conformation quality indicator may comprise detecting from the acquired optical image data a spatial color pattern or distribution exhibited by each pattern section 16 of the stamp pattern (see description above with regards to the different pattern sections). The method may then further comprise determining, based on the color pattern of each pattern section 16, and based on knowledge of the width and/or depth of the at least one depression 24 of each pattern section, an indicator of conformation quality.

More particularly, the method may comprise detecting from the color pattern for each pattern section 16 a color variation pattern across a width of at least one depression 44 of the pattern section. For each pattern section, a color uniformity metric may be determined, representative of a degree of color uniformity across the width of the at least one depression based on said detected color variation across the width of the depression. The conformation quality indicator may be determined based on comparing the color uniformity metric of each pattern section against a pre-defined standard, such as a threshold range. For example, a completely flat depression base may indicate optimal conformity, and this might be associated with a fully uniform color pattern (high color uniformity metric). A threshold level of color uniformity could be set which is associated with an acceptable degree of surface non-uniformity, this corresponding to an acceptable conformation quality. In some examples, the threshold level of color uniformity could be set based on color uniformity of a (flat) non-imprinted region surrounding the pattern 42. In other words, color variation in the grooves of the grating pattern may be compared with color variation in a flat area outside of the grating pattern.

A changing color across the width of a given depression indicates a non-uniform surface of the layer which is causing an interference pattern resulting in color variation of the reflected light. This layer height non-uniformity is caused by excess material, due to restricted flow of the layer into cavities of the imprint pattern. For example, with reference to Fig. 3(b), the area 44 would be first to experience issues with flow behavior, as the space between the stamp and wafer is the smallest, which hinders material flow more. Thus, the resulting layer surface across area 44 would become convex, e.g. material in the center of the depression is most difficult to flow out to the edge. The areas 46, may still be flat and exhibit therefore a uniform interference color. If flow becomes more restricted, then the areas 46 will become convex as not enough material can be supplied and so the stamp becomes deformed in these regions as well.

In some example, determining the conformation quality indicator may comprise identifying the maximum depression width, among the differing depressions widths of the plurality of pattern sections, for which the corresponding color uniformity metric meets said pre-defined standard. In other words, the widest depression width which still results in an acceptably even layer thickness is identified.

In some examples, determining the conformation quality indicator may comprise, for each pattern section, determining from the color variation pattern across the width of the at least one depression of the pattern section a degree of height non-uniformity across a base of said at least one depression based on an assumption that the color variation is indicative of a thin-film interference pattern of incident light through the imprintable layer.

Instead of, or in addition to, analyzing the color uniformity of a depression, the color uniformity of a peak of the pattern may be analyzed.

More particularly, the method may comprise detecting from the color pattern for each pattern section 16 a color of a non-imprinted region surrounding the imprint pattern 42.

In some examples, the color uniformity of the non-imprinted region surrounding the pattern 42 may be used as the reference against which the color uniformity of the depression 44 and/or peak 46 are compared. The non-imprinted region can be expected to be flat (i.e. uniform surface height) as a result of the initial deposition process of the imprintable layer 32 (e.g. spin coating). Thus, the color uniformity of this region can be compared with the color uniformity of the base of the depressions and/or the color of the top of the peaks to determine a degree of surface height non-uniformity.

It is noted that the different depths in the stamp pattern shown in Fig. 2 may enable the same stamp to be used for testing imprintable layers of different thicknesses. Determining conformation quality for an individual layer may require analysis of the color patterns of pattern sections of only a single depth.

In some examples, a color pattern or distribution at both the peak(s) and depression(s) of each pattern section may be detected, and this can provide additional information. A color uniformity of both the peak and depression may be determined. Initial effects of hindered material flow will present first at the lower parts of the pattern and later in both the low and high parts. By inspecting the non-uniformity in the high and low parts of the pattern, a conformation quality can be more precisely assessed.

It is noted that a surface height non-uniformity tends to be concave at the base of the depression, but tends to be convex at the top of a peak. During imprinting, the material flows from the areas that protrude in the stamp to the areas that are elevated. If, due to material properties of the layer, the flow is hindered, the material at the protruding stamp cannot be squeezed out fully, and the rubber stamp deforms under capillary forces and becomes curved. At the edges of the patterns, material only needs to flow a short distance, so the full height and deepest pattern depth is most easily reached. From the center of the protrusion / depression the material needs to flow over the longest distance and so this is hindered most. If the viscosity is too high, not all the material will be able to flow or be transported between the stamp and the substrate and this causes the convex / concave surface relief patterns.

It is noted that although the above descriptions refer to capturing a color pattern and a color of the depressions and peaks, more generally, the method may comprise capturing a spectral pattern, and spectral characteristics of a portion of the pattern corresponding to the depression and peaks.

The method may comprise determining a quantitative conformation quality indicator. This might be computed based on determining a degree of color non-uniformity across a width of each of the depressions 44 or peaks 46 of the imprint pattern 42. The degree of color non-uniformity across depression widths of each grating pitch may then be compared with one or more predetermined thresholds for that pitch to derive an indicator of layer-stamp conformation quality. For example, a lookup table may record a set of different thresholds corresponding to different quantitative values of the conformation quality indicator.

It is noted that the above method, including the application of the stamp, the curing, and the acquisition of the optical data should be performed under controlled environmental conditions: e.g. controlled humidity, pressure, and/or temperature. If the material of the imprintable layer is light sensitive, the light intensity conditions should also be controlled.

By way of illustration, Fig. 4 shows two example sets A, B of optical image data, for two sample imprintable layers 32 imprinted with a test stamp 12 in accordance with embodiments of the present invention. Image data set B corresponds to a sample 4 hours after curing, left at a temperature of 20°C. Image data set A corresponds to a sample 24 hours after curing (aged), again left at a temperature of 20°C. The two image data sets are labelled (top) in accordance with the period (in microns) of each grating.

In the four hour sample, there is good color uniformity across line widths (and therefore good layer quality) for grating periods of up to a maximum of 32 micron (32 and smaller show uniform color across each line width). While for the sample at 24h, the material viscosity is higher, and the color uniformity across line widths is only good up to a maximum period of 8 microns. This demonstrates the principle that layer viscosity, and therefore layer-stamp conformation quality, is detectable in the color pattern uniformity upon illumination of the imprinted layer. Finding the maximum depression width at which the color uniformity is high, provides an index of layer conformation quality.

The image data sets have been reproduced in black and white for this application, but in practice would contain full color information. Their representation here is for purposes of illustration, albeit limited in view of the black and white reproduction.

Each image data set represents a stamp which includes a plurality of pattern sections, each comprising a line grating having a different respective pitch. The line grating pitches vary from 2 µm to 256 µm in each sample.

Variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality.

The mere fact that certain measures are recited in mutually different dependent claims does not indicate that a combination of these measures cannot be used to advantage.

If the term "adapted to" is used in the claims or description, it is noted the term "adapted to" is intended to be equivalent to the term "configured to".

Any reference signs in the claims should not be construed as limiting the scope.

## Claims

1. A quality control method for use in imprint lithography, the method comprising:
providing a patterned stamp (12) for patterning an imprintable layer (32), the stamp comprising a pliable stamp layer (14) carrying a pattern of relief features which define a stamp pattern,
wherein the stamp pattern comprises a plurality of pattern sections (16), the pattern sections spaced from one another, and wherein each pattern section comprises pattern features (22) for forming at least one depression (44) of a respective width which is different compared to that of the other pattern sections;
applying the stamp to an imprintable layer (32) disposed on a substrate (34), the imprintable layer comprising a curable imprintable medium, whereby the imprintable layer is induced to conform to the stamp pattern;
acquiring optical imaging data of the formed imprint pattern in the imprintable layer;
deriving, based on the optical imaging data and based on knowledge of the differing depression widths and/or depths of the pattern sections, a conformation quality indicator indicative of layer-stamp conformation quality.

2. The method of claim 1, wherein each pattern section (16) comprises relief features (22) which define a respective grating of parallel lines for forming line depressions (44) in the imprintable layer (32), the grating having a grating pitch and a grating duty cycle which together define a uniform grating line width of each of the line depressions, and a grating depth which defines a depth of each of the line depressions.

3. The method of claim 2, wherein the grating of each of the plurality of pattern sections (16) has a different respective line pitch compared to the other pattern sections, the different respective line pitch resulting in a different grating line width compared to the other pattern sections.

4. The method of claim 3, wherein the plurality of pattern sections (16) include at least a first set (18a) of two or more gratings, and a second set (18b) of two or more gratings, the gratings of the first set comprising lines of a first depth, and the gratings of the second set comprising lines of a second depth, and wherein each of the first and second sets of gratings include gratings respectively of a plurality of different line pitches and/or grating duty cycles.

5. The method of any of claims 2-4, wherein the grating line width of each grating is between 0.5 and 200 micrometers.

6. The method of any of claims 1-5, wherein the determining the conformation quality indicator comprises
detecting from the optical image data a spatial color distribution or pattern exhibited by each pattern section, and
determining based on the color pattern of each pattern section, and based on knowledge of the width and/or depth of the at least one depression of each pattern section, an indicator of conformation quality.

7. The method of claim 6, further comprising detecting from the color pattern for each pattern section a color variation pattern across a width of the at least one depression.

8. The method of claim 7, further comprising determining for each pattern section a color uniformity metric representative of a degree of color uniformity across the width of the at least one depression based on said detected color variation across the width of the depression.

9. The method of claim 8, further comprising determining the conformation quality indicator based on comparing the color uniformity metric of each pattern section against a pre-defined standard, such as a threshold range.

10. The method of claim 9, wherein the determining the conformation quality indicator comprises identifying the maximum depression width, among the differing depressions widths of the plurality of pattern sections, for which the corresponding color uniformity metric meets said pre-defined standard.

11. The method of any of claims 8-10, further comprising detecting from the color pattern for each pattern section a degree of color uniformity of one or more of: a peak of the imprint pattern section, and a non-imprinted region surrounding the pattern.

12. The method of claim 11 in combination with claim 9, wherein, for each pattern section, the detected degree of color uniformity of the peak of the imprint pattern section or of the non-imprinted region surrounding the pattern is used as said pre-defined standard .

13. The method of any of claims 7-11, wherein determining the conformation quality indicator comprises, for each pattern section, determining from the color variation pattern across the width of the at least one depression of the pattern section a degree of height non-uniformity across a base of said at least one depression based on an assumption that the color variation is indicative of a thin-film interference pattern of incident light through the imprintable layer.

14. The method of any of claims 1-13, wherein the stamp is a Substrate Conformal Imprint Lithography (SCIL) stamp.

15. An imprint lithography stamp (12) having a patterned surface for patterning an imprintable layer (32), the stamp comprising a pliable stamp layer (14) carrying a pattern of relief features (22) which define a stamp pattern,
wherein the stamp pattern comprises a plurality of pattern sections (16), the pattern sections spaced from one another, and wherein each pattern section comprises pattern features (22) for forming one or more depressions (44) of a respective width and/or depth which is different compared to the other pattern sections.

16. The stamp of claim 15, wherein each pattern section comprises relief features (22) which define a respective grating of parallel lines for forming line depressions (44) in the imprintable layer, the grating having a grating pitch and a grating duty cycle which together define a uniform grating line width of each of the line depressions, and a grating depth which defines a depth of each of the line depressions.
